**Europäisches Patentamt**

**European Patent Office**

**Office européen des brevets**

(19)

(11) Publication number : **0 284 263 B1**

(12) **EUROPEAN PATENT SPECIFICATION**

(45) Date of publication of patent specification :
07.12.94 Bulletin 94/49

(51) Int. Cl.$^5$ : **H03K 19/094, H01L 27/06**

(21) Application number : **88302198.2**

(22) Date of filing : **14.03.88**

(54) **Cascade FET logic circuits.**

(30) Priority : **13.03.87 US 25899**

(43) Date of publication of application :
**28.09.88 Bulletin 88/39**

(45) Publication of the grant of the patent :
**07.12.94 Bulletin 94/49**

(84) Designated Contracting States :
**DE FR GB IT NL**

(56) References cited :
**EP-A- 0 110 701**
**EP-A- 0 226 678**
**WO-A-83/04352**
**IEEE JOURNAL OF SOLID-STATE CIRCUITS,
vol. SC-22, no. 6, December 1987, page 1031,
K.-Y. TOH et al.: "Wide-band, low-noise,
matched-impedance amplifiers in submic-
rometer MOS technology"**
**IEEE TRANSACTIONS ON ELECTRON DE-
VICES, vol. ED-27, no. 6, June 1980, pages
1074-1091, New York, US; K. LEHOVEC et al.:
"Analysis of GaAs FET's for integrated logic"**
**IEEE TRANSACTIONS ON ELECTRON DE-
VICES, vol. ED-27, no. 6, July 1980, pages
1102-1109, New York, US; G. NUZILLAT et al.:
"Quasi-normally-off MESFET logic for high-
performance GaAs IC's"**

(56) References cited :
**IBM TECHNICAL DISCLOSURE BULLETIN,
vol. 29, no. 7, December 1986, pages
2885-2886, New York, US; "Digital driver with
MESFETS having three different threshold vol-
tages"**
**PROCEEDINGS OF THE IEEE, vol. 70, no. 1,
January 1982, pages 35-45, New York, US; S.I.
LONG et al.: "High speed GaAs integrated
circuits"**
**IEEE TRANSACTIONS ON MICROWAVE
THEORY AND TECHNIQUES, vol. MTT-35, no.
3, March 1987, pages 245-249; P.T. GREILING:
"High-speed digital IC performance outlook"**

(73) Proprietor : **GOULD ELECTRONICS INC.**
**35129 Curtis Boulevard**
**Eastlake, Ohio 44095-4001 (US)**
Proprietor : **JAPAN ENERGY CORPORATION**
**10-1, Toranomon 2-chome**
**Minato-ku, Tokyo (JP)**

(72) Inventor : **Lach, Lawrence E.**
**3428 W. Drummon Place**
**Chicago Illinois 60647 (US)**
Inventor : **Ohoka, Mikiharu**
**804 S. Saratoga Ave**
**Apt B 119**
**San Jose California 95129 (US)**

(74) Representative : **Dawson, Elizabeth Ann**
**A.A. THORNTON & CO.**
**Northumberland House**
**303-306 High Holborn**
**London WC1V 7LE (GB)**

EP 0 284 263 B1

## Description

## BACKGROUND OF THE INVENTION

The present invention is directed to logic circuits formed from group III-V semiconductor compounds. In particular, the present invention is directed to integrated logic circuits formed from gallium arsenide (GaAs) field effect transistors (FETs), which include junction field effect transistors (J-FETs) or metal semiconductor field effect transistors (MESFETs).

The need for very high speed analog and digital logic circuits has led to the development of field effect transistors comprised of group III-V compounds, in particular gallium arsenide. In analog circuits, GaAs FETs employed are discrete or integrated components which are used in, for example, analog communications amplifiers. Small signal processing techniques are employed in these analog circuits, and the resultant device can operate at typically 30 GHz while employing narrow band signals. With respect to digital logic circuits, attempts have been made to manufacture gallium arsenide (GaAs) digital circuits (including GaAs MESFETs, diodes, etc.) on a semi-insulating gallium arsenide wafer. GaAs digital logic circuits operate at a lower frequency than that required for analog logic circuits. Although the frequency employed in GaAs digital logic circuits is approximately one-tenth that of analog circuits, the frequency is nevertheless still very high for digital logic circuits.

GaAs digital logic circuits have been made principally for research purposes and with only limited commercialization due to a variety of technical problems. One of the problems which occurs in the manufacture of GaAs digital logic circuits is that the FETs in the circuit can have relatively large leakage currents from their gates to their source/drain paths. These large leakage currents can increase power dissipation of the logic and degrade the switching characteristics of the circuit. Also, inherent Schottky diodes are formed in GaAs devices, and these inherent Schottky diodes produce currents which are exponential functions of the relative voltages within the circuit. Thus, it is difficult to describe and predict the various voltages and operating characteristics of the circuits. In addition, a uniform ratio of Ga to As is required, but difficult to obtain since the methods for making GaAs substrates and devices have not been perfected and are not highly controllable. Therefore, many design variables and fluctuations in the circuit characteristics occur.

A number of attempts have been made to design and manufacture GaAs digital logic circuits, including integrated circuits (ICs), because they have higher speed due to their intrinsic characteristics of having a higher carrier mobility and lower power requirements. In order to provide GaAs digital logic ICs, the logic circuits developed so far have required relatively complicated circuit structures in order to have consistent operating characteristics within the IC circuit die (i.e., chip) or from die to die.

It should be noted that bipolar and metal oxide semiconductor (MOS) transistors are not typically fabricated from GaAs. That is, GaAs MOS and bipolar transistors are difficult to fabricate. With respect to fabricating MOS devices, a good insulating oxide cannot be formed on the GaAs substrate. With respect to fabricating bipolar devices, it is difficult to form heterojunctions in the GaAs substrate. Although it is possible, it is not commercially feasible. Field effect transistors (FETs) are therefore the most likely candidate for employing GaAs technology. However, unlike silicon FETs, which often isolate the gate from the channel by means of a thermally grown oxide layer, GaAs FETs must be fabricated with a metal gate layer in direct contact with either an epitaxial GaAs layer or an ion-implanted GaAs layer which is defined to include channel regions. Attempts to form insulating layers on the GaAs substrate have proven to be unsuccessful. As a result, the metal gate in the channel region of the FET forms an inherent Schottky diode which, when forward biased, conducts relatively well. The conductive Schottky diode causes many GaAs MESFET logic devices to have undesirable relatively low input impedances.

Various types of GaAs FET logic circuits have been proposed to overcome the above-mentioned problems. However, a number of the proposed circuits require three power supplies and have low integration densities because many circuit components are required in order to produce a desired logic function.

Digital GaAs logic circuits which have been proposed in the prior art belong to one of two categories, depending upon the processing technology used. An example of a logic which is typical of the first category is buffered FET logic (BFL), which employs FET technology and includes only depletion type GaAs circuits which can be manufactured using a simple process and which depend on a single depletion type transistor. The depletion transistors are relatively easy to fabricate and are faster than corresponding silicon devices. Therefore, the first families of GaAs digital logic ICs were made of all depletion type devices. These logic circuits, however, are structurally complex since they require many transistors in order to provide a functioning circuit. The disadvantages of this category of logic circuits are that significant power is dissipated in the circuits, the circuits are structurally complex and a large area is required.

An example of a logic which is typical of the second category of logic circuits is referred to as direct coupled FET logic (DCFL) and is structurally the simplest type of logic within this category. DCFL has a higher integration density and lower power consumption than that of BFL, but it is not as fast as BFL, although it is still faster than silicon devices. A basic DCFL circuit includes a load connected to an enhancement type transistor. The principal drawback to DCFL is its threshold voltage sensitivity. An additional drawback to DCFL is its temperature sensitivity. The temperature sensitivity manifests itself as both a shift in the threshold voltage and an exponential increase in Schottky current. Although the circuit switches properly when operating at room temperature, when operating at a temperature higher than room temperature, the logic circuit may not function. In addition, DCFL degrades with fan-out since when two or more DCFL circuits are connected together, an input Schottky diode at the next stage limits the high logic level and the voltage swing is compressed. Therefore, the greater the number of logic gates connected together, the higher the equivalent load and the greater the limitation of the logic high and the corresponding reduction in logic swing. In summary, DCFL operation starts degrading at temperatures slightly higher than room temperature. Further, when fan-out is increased, the circuit is not commercially feasible for most logic functions.

One approach to overcoming GaAs digital logic IC problems is disclosed in "Analysis of GaAs FETs for Integrated Logic," Lehovec et al., IEEE Transactions on Electron Devices, Volume ED-27, No. 6, June 1980, pp 1074-1091. This publication discloses a GaAs FET circuit in FIG. 19 on page 1085. The input buffer circuit shown in FIG. 19 is a type of DCFL logic and includes a first enhancement FET $Q_1$ connected in series with a first resistor R1, with the connection point therebetween connected to a gate of a second enhancement type FET $Q_2$ A second resistor R2 is connected to the drain of the second enhancement type FET $Q_2$, and a connection node is connected to an output terminal. The use of the fixed resistor R1 is conventional in the art of circuit design and $Q_1$ and R1 comprise a portion of a source follower circuit. The principal disadvantage of this type of circuit is that resistors are difficult to process and define uniformly in a GaAs manufacturing process, so that non-uniform circuit characteristics are produced. In addition, resistors tend to require either significant layout area or dissipate significant power. Since the number of components which may be fabricated on a die is limited in part by the uniformity of device characteristics, the layout requirements and the thermal dissipation of the components, the circuit in Lehovec et al appears relatively unsuited for higher levels of integration.

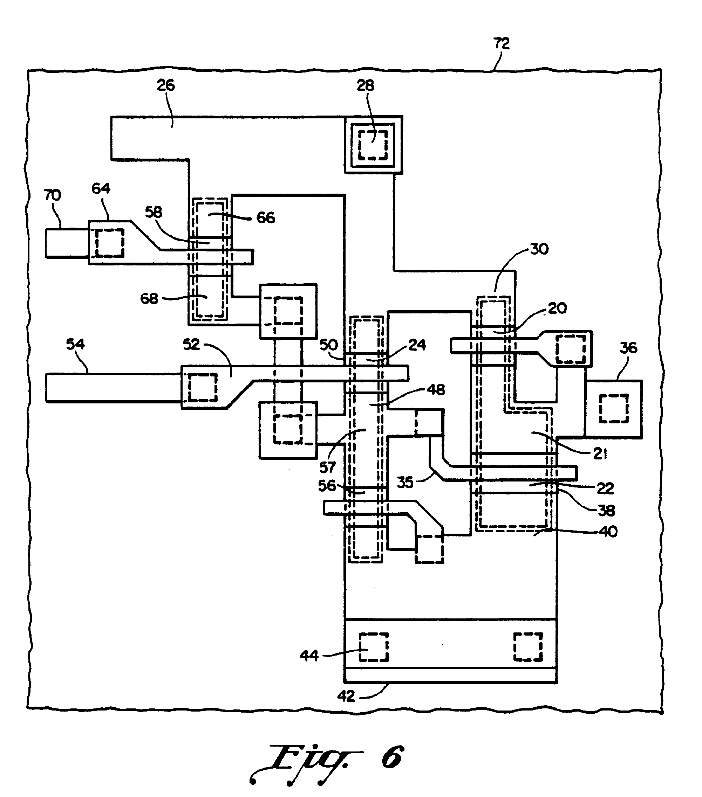

Another GaAs digital logic circuit is disclosed in Proceedings of the IEEE, vol. 70 (1982) Jan No. 1, see particularly Figure 4(a) on page 38. Here an elemental 3-input NOR gate is shown using a MESFET or JFET as the switching device. As with the above described arrangement, fixed resistors are used, namely a first fixed load resistor and a second fixed pull-down resistor for driving the FET. Thus, the same disadvantage as described above are present.

WO-A-8304352 discloses GaAs digital logic circuits aimed at providing improved fan-out capability, which use enhancement-mode field effect transistors. The circuits described use a maximum of three transistors.

EP-A-0110701 discloses (in Figure 12) a GaAs input buffer circuit having a first pair of transistors connected to a third transistor. This circuit is relatively complicated since it requires a grounding potential and three other potentials to drive it.

A driver circuit utilising three MESFETs of differing threshold voltages is disclosed in IBM Technical Disclosure Bulletin, Vol. 29, No. 7, December 1986, pages 2885 and 2886. Prior to this disclosure it had been standard practice in driver circuits to use only MESFETs with two threshold voltages.

In summary, there is a need in the art for a GaAs digital logic IC having a low power consumption, high integration density, and fast switching speed. There is also a need for such a logic circuit which is easy to manufacture, employs existing process technology, and is compatible with the supply voltages of standard silicon technology, specifically emitter coupled logic (ECL) technology.

SUMMARY OF THE INVENTION

It is an object of the present invention to provide a group III-V digital logic circuit having a compact layout and potentially high integration density.

It is another object of the present invention to provide a group III-V digital logic circuit having a potentially higher fan-out and higher fan-in than prior art devices, without significant power dissipation.

It is still another object of the present invention to provide a group III-V digital logic circuit having large noise margins and which is substantially insensitive to variations in the threshold voltages of the component transistors.

It is another object of the present invention to provide a group III-V digital logic circuit having simplified supply voltage requirements, such that only two power supplies are required.

It is a further object of the present invention to provide a group III-V digital logic circuit having exceptional high temperature operation.

It is another object of the present invention to provide a group III-V digital logic IC in which the inherent significant variations in the various characteristics of each of the component do not adversely affect the device to a prohibitive degree, and therefore provide a circuit which can be commercially produced.

It is still another object of the present invention to provide a group III-V digital logic IC which is compatible with the supply voltages of standard silicon technology, and in particular, the supply voltages of emitter coupled logic (ECL) circuits.

It is another object of the present invention to provide a group III-V digital logic IC having a simple, compact layout and potentially high integration density.

The present invention provides an integrated logic circuit, comprising:

a group III-V compound semiconductor substrate;

an input signal terminal;

an output signal terminal;

a first power supply node;

a second power supply node;

a first field effect transistor on said semiconductor substrate, having a first gate coupled to the input signal terminal, having a first drain coupled to the first power supply node, and having a first source;

a second field effect transistor on said semiconductor substrate having a second gate coupled to said first source of said first field effect transistor, having a second source coupled to the second power supply node, and having a second drain coupled to the output signal terminal;

a third field effect transistor on said semiconductor substrate, having a third gate, having a third source coupled to the third gate and having a third drain, wherein said first power supply node is coupled to the third drain of said third field effect transistor and the third source of the third field effect transistor is coupled to the output signal terminal;

characterised by having a fourth field effect transistor on said semiconductor substrate having a fourth drain coupled to said first source of said first field effect transistor, having a fourth gate and having a fourth source coupled to said fourth gate and to the second power supply node; and

wherein each of said first through fourth field effect transistors is a junction field effect transistor (JFET) or a metal semiconductor field effect transistor (MESFET), said first and second field effect transistors have a first threshold voltage, said third and fourth field effect transistors have a second threshold voltage which is less than the first threshold voltage, and the difference between the first threshold voltage and the second threshold voltage is equal to a constant, said constant being determined in accordance with widths of said field effect transistors.

In preferred embodiments, the first and second FETs are enhancement mode FETs and the load is a depletion mode FET. In addition, the FETs can be metal semiconductor field effect transistors (MESFETs) or junction field effect transistors (J-FETs) formed as an integrated circuit (IC) with a group III-V substrate, in particular, a GaAs substrate.

Further, a fifth FET having the first threshold voltage can be provided. The fifth FET has a gate coupled to receive a second input signal, a drain coupled to the drain of the first transistor and the first power source, and a source coupled to the source of the first transistor. In preferred embodiments, the FETs can be either MESFETs of J-FETs. The first, second and fifth FETs are preferably enhancement mode transistors and the third and fourth FETs are preferably depletion mode transistors. All of the FETs (MESFETs or J-FETs) are preferably formed from materials selected from group III-V semiconductors, in particular, GaAs. The logic circuit formed is a two-input NOR gate from which any type of desired logic circuit can be formed as an integrated circuit. This is accomplished by connecting various combinations of NOR gates. Preferably, the first and second transistors have a first threshold voltage and the third and fourth transistors have a second threshold voltage. The second threshold voltage is preferably less than zero, and the first threshold voltage is preferably greater than the second threshold voltage. In addition, the difference between the first threshold voltage and the second threshold voltage is preferably equal to a constant determined in accordance with the widths of the transistors.

These objects, together with all other objects and advantages which will be subsequently apparent, reside in the details of construction and operation as more fully hereinafter described and claimed, reference being had to the accompanying drawings forming a part hereof, wherein like reference numerals refer to like parts throughout.

## BRIEF DESCRIPTION OF THE DRAWINGS

FIG. 1 is a circuit diagram of a logic inverter which is shown for illustration purposes;

FIG. 2 is a circuit layout including the circuit in FIG. 1;

FIG. 3 is a sectional view taken along the line A-A in FIG. 2;

FIG. 4 is a sectional view taken along line B-B in FIG. 2;

FIG. 5 is a circuit diagram of a two input-NOR circuit according to an embodiment of the present invention;

FIG. 6 is a circuit layout including the circuit in FIG. 5; and

FIGS. 7A-7C are graphs of the temperature and voltage characteristics of the circuit in FIG. 5, without the additional fan-in transistor 58, compared to that of a prior art circuit.

## DESCRIPTION OF THE PREFERRED EMBODIMENTS

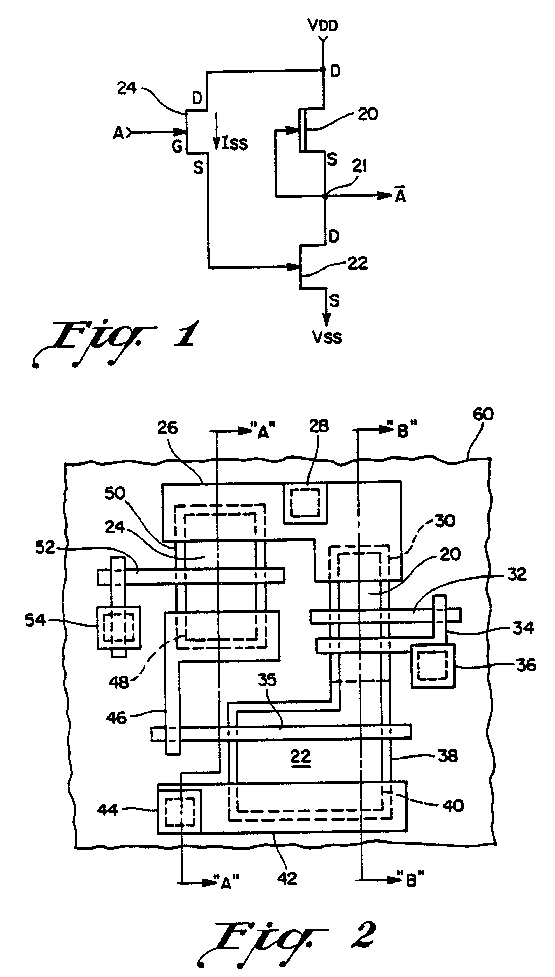

FIG. 1 is an inverter circuit made from cascade FET logic (CFL) and includes a load 20, which is a depletion type transistor, connected in series with a main FET 22 (which is either a MESFET or a J-FET, as are all the FETs disclosed hereinafter), which is an enhancement type FET. A preferred embodiment includes MESFETs. The load 20 includes a drain connected to a power source $V_{DD}$, a gate, and a source connected to the gate. The main FET 22 includes a drain connected to the source of the load 20, a source connected to a power source $V_{SS}$ and a gate. A connection node 21 is formed between the source of the load 20 and the drain of the main FET 22. An output terminal $\overline{A}$ is connected to the connection node 21. An auxiliary FET 24, which is an enhancement type FET, has a drain coupled to the drain of the load 20 and a source coupled to the gate of the main FET 22. The auxiliary FET 24 also has a gate connected to an input terminal A. The circuit functions such that when a voltage input at the input terminal A to the gate of the auxiliary FET 24 is high, the auxiliary FET 24 conducts and a current $I_{DS}$ flows from the drain to the source of the auxiliary FET 24 into the gate of the main FET 22 to drive the main FET 22. The circuits described feature two parasitic Schottky diodes located between the gates and sources of the auxiliary FET 24 and the main FET 22. The Schottky diodes increase the input impedance of the circuit and produce a larger logic swing. The active nature of the auxiliary FET 24 further serves to increase the input impedance and increase the logic swing.

This circuit solves the DC fan-out problem which occurs in the prior art DCFL circuit. That is, in FIG. 1, when additional circuits are connected to the output terminal $\overline{A}$ so that fan-out is increased, there is less degradation of the output logic swing than with prior art circuits. In DCFL, however, if two DCFL circuits are connected together the input Schottky diode at the next stage will conduct and thereby limit the logic high level and the voltage swing. Also, the greater the fan-out, the greater the equivalent Schottky area, and the greater the limitation of the logic high and reduction of the logic swing.

In the CFL circuit of FIG. 1, when the input signal is high, the auxiliary FET 24 conducts the current $I_{DS}$ which drives the main FET 22. This action increases the input impedance of the circuit. In addition, two parasitic Schottky diodes are present - one between the gate and source of the auxiliary FET 24 and one between the gate and source of the main FET 22, as set forth above. Thus, the resultant input voltage is at a level which is twice a single Schottky voltage above ground potential, and a larger logic swing results. Since the main FET 22 is driven by $I_{DS}$ and not exclusively by the input current into the auxiliary FET 24, the circuit formed by the auxiliary FET 24 and the main FET 22 is active, thereby further increasing the input impedance at the gate of the auxiliary FET 24. The circuit in FIG. 1, therefore has a higher input impedance and less degradation of the logic swing with each fan-out circuit added since less input current is drawn by each fan-out added. The magnitude of the voltage swing of the circuit in FIG. 1 can be greater than 1.0 volt when the difference between $V_{DD}$ - $V_{SS}$ is only 2.0 volts.

The process by which CFL is manufactured corresponds to typical digital group III-V semiconductor processes now employed. A preferred embodiment of a layout of an IC including the circuit of FIG. 1 is formed from group III-V semiconductor MESFET technology and is shown in FIGS. 2-4. In FIG. 2, the power source $V_{DD}$ has a connection point 28 and a supply bus 26. The load 20 includes a depletion implant boundary 30, a gate 32 and a source 34. The output terminal A is shown by reference numeral 36. The main FET 22 includes a drain 34, an enhancement implant boundary 38 and a source/drain implant boundary 40. The source 42 of the main FET 22 is the same as the $V_{SS}$ supply bus. The $V_{SS}$ connection point is represented by the reference numeral 44 in FIG. 2. The auxiliary FET 24 includes a source 46, a source/drain implant region 48, an enhancement implant boundary 50 and a gate 52. The input terminal A is shown by reference numeral 54.

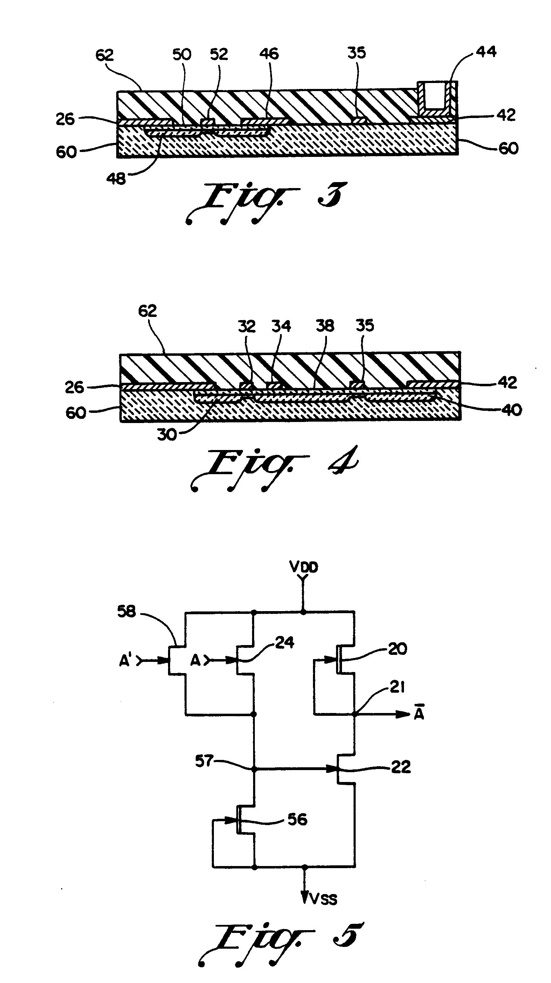

FIG. 3 is a cross-sectional view taken along the line A-A of FIG. 2. Like reference numerals correspond to like parts. Fig. 3 further shows a substrate 60 and an insulating layer 62. FIG. 4 is a cross-sectional view taken along the line B-B in FIG. 2. Like reference numerals correspond to like parts. In addition, FIG. 4 further shows the substrate 60 and the insulating layer 62. The substrate 60 is a group III-V compound semiconductor. In the preferred embodiment, the substrate 60 is formed of GaAs. The insulating layer 62 can be formed of any material normally employed, e.g., polyimide.

The circuit set forth in FIGS. 1-4 has enhanced operating characteristics and is compatible with processes already employed in the art, rather than requiring any special manufacturing processes.

In addition to the large logic swing and high input impedance of the circuit in FIG. 1, which allows for greater fan-out, the device also has a fast switching speed (at least 2 times better than logic circuits employing silicon technology). There is a problem, however, in that although the device is fast with respect to an output logic level transition from a 1 to a 0 logic level, when the output logic level transition is from a 0 to a 1 logic level, the main FET 22 does not respond as quickly as it does with respect to the transition from the output 1 to 0 logic level. This is because the Schottky current of the main FET 22 is not large enough to rapidly discharge the node voltage at its gate, and therefore there is a relatively slow turnoff time when the transistor is switched from an output 0 to 1 logic level. The following circuit, corresponding to the second embodiment of the invention improves this drawback of the circuit in Fig. 1.

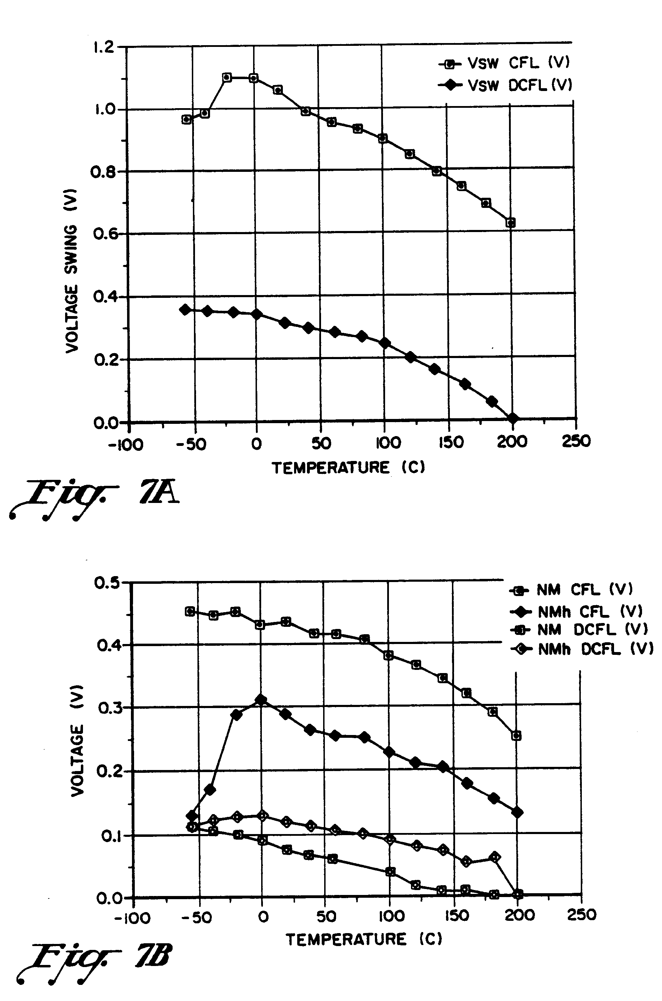

FIG. 5 is a digital logic circuit according to an embodiment of the present invention and represents a two-input NOR circuit. In this embodiment, an additional depletion type FET 56 having a drain connected to the connection point 57 has been added to improve the switching speed from the 0 to the 1 logic level. The source of the additional FET 56 is connected to the source of the main FET 22 and the power source $V_{SS}$. The gate of the additional FET 56 is connected to its source. This circuit also includes additional fan-in FET 58 which has a drain connected to $V_{DD}$, a source connected to the source of the auxiliary FET 24 and a gate connected to an additional input terminal A'. This circuit operates in substantially the same manner as set forth above with respect to FIG. 1 in that the output voltage is pulled down at a very fast speed when the output transition is from the 1 to the 0 logic level.

The additional depletion type FET 56 conducts, but not substantially, and therefore when the output transition is from the 0 to the 1 logic level there is an additional path in which to discharge the voltage at the gate of the main FET 22. That is, the additional depletion FET 56 discharges the node at the gate of the main FET 22 so that the output 0 to 1 logic level transition occurs much faster than that in the embodiment of FIG. 1, and both transition times (i.e., the transition time from the 1 to the 0 logic level and the transition time from the 0 to the 1 logic level) are significantly improved. The noise margin of the device is also improved over prior art DCFL logic circuits by a factor of 2 or more.

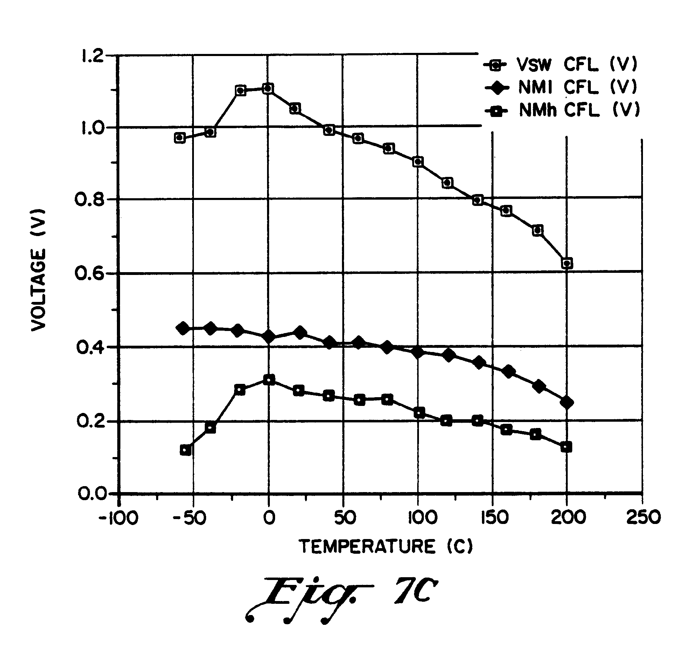

It should be noted that the circuit in FIG. 5 can be manufactured using conventional GaAs or other group III-V processing techniques. An IC layout of the circuit in FIG. 5 is shown in FIG. 6.

Although the layout in FIG. 6 is slightly different from FIG. 2, FIG. 6 includes the FETs 20, 22 and 24 and their corresponding regions as set forth in FIG. 2. Therefore, in FIG. 6, the reference numbers identifying these transistors and their respective regions are the same as in FIG. 2. In addition, FIG. 6 includes the additional fan-in FET 58 which has a drain 66 connected to the $V_{DD}$ supply bus 28 and a source 68 connected to the source 48 of the auxiliary FET 24. The additional input terminal A' is represented by reference number 70 and is connected to the gate 64 of the additional fan-in FET 58. The IC is formed on a substrate 72 which, in the preferred embodiment, is GaAs.

In group III-V processing technology, particularly GaAs, the devices formed have extremely non-linear characteristics. In GaAs, in the absence of a suitable insulating oxide or commercially feasible heterojunctions, Schottky MESFETs or J-FETs must be used. In GaAs technology, it is not easy to predict the operation of the circuits formed and the currents which flow, since the currents are not simple functions of applied voltages. Rather, the devices formed have inherent Schottky diodes so that the currents that flow are exponential functions of relative voltages and are difficult to describe and predict.

Adding the additional depletion type FET 56 to the circuit in FIG. 5 provides several significant surprising results. The first significant result to note is the role of the main FET 22 and the auxiliary FET 24 in establishing a high impedance node at the gate of the main FET 22.

One would expect that the additional depletion FET 56 would dissipate significantly more power and increase the power dissipation of the entire device, which is undesirable. It is well known in the prior art that a source follower (having a structure similar to the auxiliary FET 24 and the additional depletion FET 56) may be used to transform a relatively high impedance signal at one circuit node to correspond to a low impedance signal at another circuit node. Thus, the auxiliary FET 24 and the additional depletion FET 56 would appear to elevate the input impedance at the input terminal A. This could contribute to a significant overall increase in power dissipation which is undesirable. In addition, in DCFL the impedance level at the gate of the main transistor would tend to be low. To compensate for the Schottky currents which flow, an appropriate load element is provided for the main transistor. This load element must be sufficiently large so as to source the significant current of the load. However, the main transistor must then have a minimum transistor width or additional gate drive must be provided in order to provide an output 0 logic level. Either of these methods tends to increase the magnitude of the DC currents flowing in the main transistor, thereby further decreasing the impedance level at the gate and increasing power dissipation. Further, by minimizing the transistor width or providing additional gate drives, the parasitic Schottky capacitance at the gate of the main the transistor is increased. This decreases the AC impedance and reduces the speed of the logic gate.

In the present invention, however, the auxiliary FET 24 and the additional depletion FET 56 provide the unexpected result that they effectively elevate the impedance level at the gate of the main FET 22 relative to the impedance level which would otherwise exist at that gate. Thus, the corresponding increase in power dissipation is not observed. Rather, the elevated impedance level at the gate of the main FET 22 is a significant factor in improving both the power dissipation and the performance of the circuit.

The impedance level at the gate of the main FET 22 is defined by the magnitude of currents which flow from this node in response to an impressed voltage. This impedance level is dominated by the Schottky diode between the gate and source of the main FET 22. The DC impedance level is dominated by the magnitude of the Schottky current which is described by a well known exponential relationship. The AC impedance level is dominated by a parasitic Schottky capacitor which is described by relatively complex and highly voltage sensitive relationships. In the second embodiment of CFL, the input impedance at the input node tends to be higher than that for DCFL due to the presence of the auxiliary FET 24 and the additional depletion FET 56. Therefore, due to the higher input impedance, the magnitude of the logic swing is not significantly degraded with fan-out and the load 20 needs to output less current. Because of the reduced current of the load 20, the main FET 22 may be slightly smaller in width or may be driven less strongly at its gate. The smaller width or reduced gate drive reduces the magnitudes of the DC currents flowing at the gate of the main FET 22, thereby increasing the associated impedance level of that node and decreasing the power dissipation. In addition, the associated parasitic capacitance at the node of the main FET 22 is decreased thereby increasing the associated AC impedance level and increasing the speed of the logic gate. Thus, in CFL, the DC and AC impedance levels at the gate of the main transistor (i.e., FET 22) are relatively high, resulting in decreased power dissipation and increased speed of the device.

Another feature of the invention is that the layout requirement for the CFL circuit in both the first and second embodiments requires transistor width sizes which are very small. For example, the width of the main FET 22 can be 5 μm, the width of the auxiliary FET 24 can be 2 μm, the width of the load 20 can be 2 μm and the width of the additional depletion type FET 56 can be 2 μm. These widths are approximately the smallest sizes one can achieve when manufacturing transistors. It should be noted that the ratio of approximately 2-2-2-5 for the widths of the FETs 56, 24, 20 and 22, respectively, provides very good circuit characteristics.

In comparison, in DCFL type logic, a typical width for a load device is 3 μm and the typical width for the main transistor is approximately 10 μm. Although CFL requires more transistors than DCFL in order to achieve the same function, the total transistor area is comparable between these two types of logic circuits with the added feature that CFL also has the above-mentioned additional advantages over other types of logic circuits including DCFL and BFL.

Another major advantage of the present invention is that CFL features a substantial immunity to variations in the threshold voltages of the devices. Because of the wafer quality of GaAs, the threshold voltages of all devices are not uniform and vary over a large range on a single wafer. Therefore, the threshold voltage for any transistor is random and cannot be controlled. In DCFL, the output voltage shifts with respect to threshold voltage shifts and the logic circuit can be come inoperable.

That is, in DCFL, the sensitivity of logic to changes in threshold voltages is a major drawback since the noise margins and logic swing of DCFL devices are initially low, and therefore, slight variations in the threshold voltages which degrade noise margins and logic swing can quickly render the circuit inoperable. In CFL, however, the noise margins are better than that of, for example DCFL, by a factor of two or more and the logic swing is also larger than that of DCFL. Therefore, the circuit can tolerate larger variations in the threshold voltages. Thus, the production yield is higher than that of, for example, DCFL, because more devices can operate over a larger range of threshold voltage variations.

The higher production yield is a second significant and surprising feature of the logic. In GaAs technology, the threshold voltage of a next transistor tends to correlate or to track with transistors in the threshold voltage of a previous transistor of the same type formed adjacent thereto. Therefore, the differences between the threshold voltages of the two physically adjacent transistors of the same type tend to be small. This is true for both enhancement and depletion type transistors.

Due to this local correlation of the threshold voltages between similar adjacent transistors, one would normally expect that if the enhancement voltages increase, the voltage on the gate of the main transistor would need to be more positive to achieve a given source/drain current. If the threshold voltages of the auxiliary FET 24 tracks the threshold voltage of the main FET 22, the auxiliary FET 24 would supply less voltage to the gate of the main FET 22 than normal. Therefore, it appears that the effects of a given change in the threshold voltages will be large and undesirable, and that CFL would be very sensitive to threshold voltage variations. If this were true, then the yield of the device will be low and the device will be difficult to manufacture.

When the CFL device in FIG. 5, a GaAs digital IC MESFET, was tested, however, the simulation results showed unexpectedly that CFL is relatively insensitive to threshold voltage variations. That is, the FETS 20, 22, 24 and 56 can operate within a wide range of threshold voltage variations. With respect to the depletion FETs 20 and 56, the threshold voltages can vary, for example, within a range of approximately -1.05 to -.055 V, and for enhancement FETs 22 and 24 the threshold voltages can vary, for example, within a range of approximately -.15 through .35 V. Thus, CFL devices remain working even with substantial changes in the threshold voltages of the various FETs.

There is actually a band of threshold voltage ranges which extend indefinitely in the positive and negative directions along a diagonal between the X and Y axes of a threshold voltage sensitivity plot in which the following relationship applies:

$$V_{t1} - V_{t2} = \text{constant}$$

where $V_{t1}$ is a first threshold voltage of the enhancement type FETs 22 and 24 and $V_{t2}$ is the threshold voltage of the depletion type FETs 20 and 56. In addition, $V_{t1}$ must be greater than $V_{t2}$, and $V_{t2}$ must be less than zero. As long as the threshold voltages meet these requirements, the device will function. The constant is dependent upon the widths of the transistors. This also provides the surprising result that the enhancement mode FETs can actually become depletion mode FETs (i.e., they exhibit a negative threshold voltage) and the circuit will continue to function even when the threshold voltages are all negative.

This paradox between what is expected in the art and what actually happens, can be explained by conceptually grouping the transistors. If one recognizes that in group III-V process technology, threshold voltages can correlate well over an entire die (but not yet over a lot of wafers), then one may conceptually group the main FET 22 and the load 20 of one logic gate with the auxiliary FET 24 and the additional FET 56 of another logic gate in examining the overall threshold sensitivity. Under this conceptual grouping, the overall threshold sensitivities of CFL are seen to be relatively small. If the threshold voltages of the main FET 22 and auxiliary FET 24 are slightly more positive than targeted (for example, if the main FET 22 of one logic gate output delivers a more positive set of logic levels to the auxiliary FET 24 at another logic gate input at the same instant), the auxiliary FET 24 would require additional gate drive to maintain the operating point at its source. In this way, the absolute logic levels on the die may vary versus threshold variation, but the overall functional yield of the logic is nevertheless high.

Yet another property of CFL is the ability to define an additional fan-in with a single two micron size additional fan-in FET 58 (see FIG. 5) having a 2 m width. This circuit can handle between 3-8 fan-ins without additional transistor resizing modifications to the basic CFL circuit. This would not normally be expected since one would normally expect that the main FET 22 would need to be duplicated for each additional fan-in or, that in the very least, the size of the additional depletion FET 56 would need to be increased in order to obtain a functional operating point for the circuit. By not having to duplicate the main FET 22, no additional capacitance is added to the source node of the additional depletion FET 56, which would significantly increase propagation delay. Further, by not having to increase the size of the additional depletion FET 56, the impedance level at the gate of the main FET 22 is not reduced. Thus, the power dissipation of the logic gate is not increased and the performance characteristics of the device are not degraded. Still further, the small size of the additional fan-in FET 58 is highly desirable for the reason that it contributes to the high integration density of the device. The smaller the transistor the smaller the parasitic capacitance and conductance so that the high impedance level at the gates of the main FET 22 and the auxiliary FET 24 are maintained, as is the high speed and low power of the device. In addition, the present invention operates using only two power supplies, $V_{DD}$ and $V_{SS}$, and therefore is particularly compatible with emitter coupled logic (ECL) technology.

Another surprising advantage of CFL is that this logic can operate within an extremely wide temperature range, for example, between, at least, -50°C to 200°C. FIGS. 7A to 7C compare the voltage swing and noise margin levels of DCFL and CFL inverters (i.e., the CFL inverters including the circuit in FIG. 5 without the additional fan-in FET 58) having a fan-out of three. These early prototype results reveal that DCFL does not function at 200°C (the device stops functioning at approximately 175°C); whereas CFL circuits continue to function at 200° with only some degradation.

TABLE 1 shows the voltage swing, high level noise margin ($NM_H$) and low level noise margin ($NM_L$) differences between CFL and DCFL at temperatures of 20°C, 100°C and 200°C and having a fan-out of three. It can be seen that CFL has substantially

## TABLE 1

| Fan-Out = 3 | 20°C | 100°C | 200°C |
|---|---|---|---|
| Voltage Swing | | | |
| DCFL | .32 | .23 | .00 |
| CFL | 1.05 | .89 | .62 |
| NM$_H$ | | | |
| DCFL | .12 | .09 | .00 |
| CFL | .29 | .23 | .13 |
| NM$_L$ | | | |
| DCFL | .08 | .04 | .00 |
| CFL | .45 | .37 | .25 |

better performance characteristics than DCFL at all temperatures. The voltage swing data is taken from the graph in FIG. 7A. FIGS. 7B and 7C are graphs comparing DCFL to CFL logic with respect to temperature and voltage. It can be seen that CFL provides a logic circuit which can be used in many instances since not only does it have high speed and low power consumption due to its large voltage swing, but it is also capable of withstanding high temperatures. Thus, CFL circuits can be used in many more applications than prior digital logic circuits.

The group III-V digital logic circuits of the present invention provide significant advantages over the prior art, including DCFL and BFL, in that they have higher integration density, lower power, and higher speed, and operates at higher temperatures. The attractiveness to commercially produce devices of this type (i.e., CFL) is also greatly enhanced since CFL operates over large variations in threshold voltages and is compatible with supply voltages of silicon technology, particularly ECL. In addition, group III-V compound semiconductors, particularly GaAs, are inherently superior to silicon technology in areas of speed and power performance. (In general, GaAs devices are 3 to 5 times faster and dissipate power 4 to 6 times better than silicon devices.) The GaAs digital logic circuits of the present invention provides surprising results over those expected particularly with respect to threshold voltage variations and temperature. Further, they employ existing processing technology and are compatible with the supply voltage standards of silicon devices making them attractive for commercial production.

With respect to employing J-FETs in the logic circuit, it is predicted that improved circuit characteristics over those of even MESFET circuits will result. In J-FETs, a p-type implant is provided only in the portion of the substrate on which a gate is to be formed. A gate is then formed on the p-type implant. This reduces the leakage current flowing from the gate to the source and theoretically should improve the switching characteristics of the device. It is predicted that the operating temperature may also increase over that of MESFET circuits. The only drawback of J-FET technology is that it requires difficult processing techniques. Thus, in choosing between MESFET and J-FET technology there is a trade off between more difficult processing techniques and improved performance characteristics of J-FET circuits compared to less difficult processing techniques and performance characteristics (which are very good, but not quite as good as those expected from J-FET technology) of MESFET circuits.

The foregoing is considered as illustrative only of the principles of the invention. Further, since numerous modifications and changes will readily occur to those skilled in the art, it is not desired to limit the invention to the exact construction and applications shown and described, and accordingly, all suitable modifications and equivalents may be resorted to, falling within the scope of the appended claims. For example, the CFL inverter circuit including the additional fan-in FET 58 which forms a two input NOR circuit can be combined with other two input NOR circuits to form any other logic circuit desired, i.e., three-input NOR gates can be produced by providing another FET in parallel with FET 56, etc. In addition, any group III-V semiconductor compound, e.g., InP, can be employed.

**Claims**

1. An integrated logic circuit, comprising:

a group III-V compound semiconductor substrate (60);

an input signal terminal (A);

an output signal terminal ($\overline{A}$);

a first power supply node ($V_{DD}$);

a second power supply node ($V_{SS}$);

a first field effect transistor (24) on said semiconductor substrate (60), having a first gate coupled to the input signal terminal (A), having a first drain coupled to the first power supply node ($V_{DD}$), and having a first source;

a second field effect transistor (22) on said semiconductor substrate (60) having a second gate coupled to said first source of said first field effect transistor (24), having a second source coupled to the second power supply node ($V_{SS}$), and having a second drain coupled to the output signal terminal ($\overline{A}$);

a third field effect transistor (20) on said semiconductor substrate, having a third gate, having a third source coupled to the third gate and having a third drain, wherein said first power supply node ($V_{DD}$) is coupled to the third drain of said third field effect transistor and the third source of the third field effect transistor is coupled to the output signal terminal ($\overline{A}$);

characterised by having a fourth field effect transistor (56) on said semiconductor substrate having a fourth drain coupled to said first source of said first field effect transistor (24), having a fourth gate and having a fourth source coupled to said fourth gate and to the second power supply node ($V_{SS}$); and

wherein each of said first through fourth field effect transistors is a junction field effect transistor (JFET) or a metal semiconductor field effect transistor (MESFET), said first and second field effect transistors (24,22) have a first threshold voltage, said third and fourth field effect transistors (20,56) have a second threshold voltage which is less than the first threshold voltage, and the difference between the first threshold voltage and the second threshold voltage is equal to a constant, said constant being determined in accordance with widths of said field effect transistors.

2. An integrated logic circuit as set forth in claim 1, further characterised in that said third field effect transistor (20) is a depletion type.

3. An integrated logic circuit as set forth in claim 1 or 2, further characterized in that said fourth field effect transistor (56) is of a depletion type.

4. An integrated logic circuit as set forth in any one of claims 1-3, further characterized in that said fourth field effect transistor (56) is a metal semiconductor field effect transistor.

5. An integrated logic circuit as set forth in claim 4, further characterized in that said third field effect transistor (20) is a metal semiconductor field effect transistor.

6. An integrated logic circuit as set forth in any preceding claim, further characterized in that said first and second field effect transistors (24,22) are metal semiconductor field effect transistors.

7. An integrated logic circuit as set forth in any one of claims 1 to 3, further characterized in that said fourth field effect transistor (56) is a junction-field effect transistor.

8. An integrated logic circuit as set forth in claim 7, further characterized in that said third field effect transistor (20) is a junction field effect transistor.

9. An integrated logic circuit as set forth in claims 7 or 8, further characterized in that said first and second field effect transistors (24,22) are junction field effect transistors.

10. An integrated logic circuit as set forth in any preceding claim, further characterized in that said first, fourth, third and second transistors (24,56,20,22) have widths having a ratio of approximately 2-2-2-5, respectively.

11. An integrated logic circuit as set forth in claim 10, further characterized in that the width of each of said first, fourth and third transistors (24,56,20) is substantially two micrometers, and wherein the width of said second transistor (22) is substantially five micrometers.

12. An integrated logic circuit as set forth in any preceding claim, further characterized in that the second threshold voltage is less than zero.

13. An integrated logic circuit as set forth claim 12, further characterized by including:
a second input signal terminal (A'); and
a fifth field effect transistor (58) on said substrate (60) having the first threshold voltage, having a gate coupled to the second input signal terminal (A'), having a drain coupled to said drain of said first transistor (24) and to the first power source ($V_{DD}$), and having a source coupled to said source of said first transistor (24).

14. An integrated logic circuit as set forth in claim 13, further characterized in that said fifth transistor (58) is a metal semiconductor field effect transistor.

15. An integrated logic circuit as set forth in claim 13, further characterized in that said fifth transistor (58) is a junction field effect transistor.

16. An integrated logic circuit as set forth in any one of claims 13 to 15, further characterized in that said logic circuit is a two-input NOR circuit.

17. An integrated logic circuit as set forth in claim 13, further characterized in that a plurality of said two-input NOR circuits are connected together to form said integrated logic circuits.

18. An integrated logic circuit as set forth in any one of claims 1 to 17, further characterized in that respective power sources providing power to said first and second power supply nodes ($V_{DD}$, $V_{SS}$) during operation of said logic circuit are compatible with silicon circuits.

19. An integrated logic circuit as set forth in any one of claims 1 to 18, further characterized in that said logic circuit includes only the first and second power sources.

20. An integrated logic circuit as set forth in any one of claims 1 to 19, further characterized in that said substrate (60) includes GaAs.

21. An integrated logic circuit as set forth in any one of claims 1-4, further characterized in that said logic circuit includes a plurality of fan-out transistors.

22. An integrated logic circuit as set forth in any one of claims 1-21, said logic circuit being made from cascade FET logic (CFL).

## Patentansprüche

1. Eine integrierte, logische Schaltung, umfassend:
ein Halbleitersubstrat (60) aus einer Verbindung der Gruppe III-V;
eine Eingangssignalklemme ($\underline{A}$);
eine Ausgangssignalklemme ($\bar{A}$);
einen ersten Stromzuführknoten ($V_{DD}$);
einen zweiten Stromzuführknoten ($V_{SS}$);
einen ersten Feldeffekt-Transistor (24) auf dem genannten Halbleitersubstrat (20), der ein erstes Gate hat, das mit der Eingangssignalklemme (A) gekoppelt ist, eine erste Drain hat, die mit dem ersten Stromzuführknoten ($V_{DD}$) gekoppelt ist, und eine erste Source hat;
einen zweiten Feldeffekt-Transistor (22) auf dem genannten Halbleitersubstrat (60), der ein zweites Gate hat, das mit der genannten ersten Source des genannten ersten Feldeffekt-Transistors (24) gekoppelt ist, eine zweite Source hat, die mit dem zweiten Stromzuführknoten ($V_{SS}$) gekoppelt ist, und eine zweite Drain hat, die mit der Ausgangssignalklemme ($\overline{A}$) gekoppelt ist;

einen dritten Feldeffekt-Transistor (60) auf dem genannten Halbleitersubstrat, der ein drittes Gate hat, eine dritte Source hat, die mit dem dritten Gate gekoppelt ist, und eine dritte Drain hat, wobei der genannte erste Stromzuführknoten ($V_{DD}$) mit der dritten Drain des genannten dritten Feldeffekt-Transistors gekoppelt ist und die dritte Source des dritten Feldeffekt-Transistors mit der Ausgangssignalklemme ($\overline{A}$) gekoppelt ist;

**gekennzeichnet durch** einen vierten Feldeffekt-Transistor (56) auf dem genannten Halbleitersubstrat, der eine vierte Drain, die mit der genannten ersten Source des genannten ersten Feldeffekt-Transistors (24) gekoppelt ist, ein viertes Gate hat und eine vierte Source hat, die mit dem genannten vierten Gate und dem zweiten Stromzuführknoten ($V_{SS}$) gekoppelt ist; und

in der der genannte erste bis vierte Feldeffekt-Transistor ein Feldeffekt-Transistor mit Heteroübergang (JFET) oder ein Metall-Halbleiter-Feldeffekt-Transistor (MESFET) ist, wobei der genannte erste und zweite Feldeffekt-Transistor (24, 22) eine erste Schwellenspannung haben, der genannte dritte und vierte Feldeffekt-Transistor (20, 56) eine zweite Schwellenspannung haben, die kleiner als die erste Schwellenspannung ist, und der Unterschied zwischen der ersten Schwellenspannung und der zweiten Schwellenspannung gleich einer Konstanten ist, wobei die genannte Konstante gemäß der Weiten der genannten Feldeffekt-Transistoren bestimmt wird.

2. Eine integrierte, logische Schaltung, wie in Anspruch 1 angegeben, ferner **dadurch gekennzeichnet**, daß der genannte dritte Feldeffekt-Transistor (20) ein Verarmungstyp ist.

3. Eine integrierte, logische Schaltung, wie in Anspruch 1 oder 2 angegeben, ferner **dadurch gekennzeichnet**, daß der genannte vierte Feldeffekt-Transistor (56) ein Verarmungstyp ist.

4. Eine integrierte, logische Schaltung, wie in irgendeinem der Ansprüche 1-3 angegeben, ferner **dadurch gekennzeichnet**, daß der genannte vierte Feldeffekt-Transistor (56) ein Metall-Halbleiter-Feldeffekt-Transistor ist.

5. Eine integrierte, logische Schaltung, wie in Anspruch 4 angegeben, ferner **dadurch gekennzeichnet**, daß der genannte dritte Feldeffekt-Transistor (20) ein Metall-Halbleiter-Feldeffekt-Transistor ist.

6. Eine integrierte, logische Schaltung, wie in irgendeinem vorhergehenden Anspruch angegeben, ferner **dadurch gekennzeichnet**, daß der genannte erste und zweite Feldeffekt-Transistor (24, 22) Metall-Halbleiter-Feldeffekt-Transistoren sind.

7. Eine integrierte, logische Schaltung, wie in irgendeinem der Ansprüche 1 bis 3 angegeben, ferner **dadurch gekennzeichnet**, daß der genannten vierte Feldeffekt-Transistor (56) ein Feldeffekt-Transistor mit Heteroübergang ist.

8. Eine integrierte, logische Schaltung, wie in Anspruch 7 angegeben, ferner **dadurch gekennzeichnet**, daß der genannte dritte Feldeffekt-Transistor (20) ein Feldeffekt-Transistor mit Heteroübergang ist.

9. Eine integrierte, logische Schaltung, wie in Anspruch 7 oder 8 angegeben, ferner **dadurch gekennzeichnet**, daß der genannte erste und zweite Feldeffekt-Transistor (24, 22) Feldeffekt-Transistoren mit Heteroübergang sind.

10. Eine integrierte, logische Schaltung, wie in irgendeinem vorhergehenden Anspruch angegeben, ferner **dadurch gekennzeichnet**, daß der erste, vierte, dritte und zweite Transistor (24, 56, 20, 22) Weiten mit einem jeweiligen Verhältnis von ungefähr 2-2-2-5 haben.

11. Eine integrierte, logische Schaltung, wie in Anspruch 10 angegeben, ferner **dadurch gekennzeichnet**, daß die Weite von jedem des genannten ersten, vierten und dritten Transistors (24, 56, 20) im wesentlichen zwei Mikrometer ist, und in der die Weite des genannten zweiten Transistors (22) im wesentlichen fünf Mikrometer ist.

12. Eine integrierte, logische Schaltung, wie in irgendeinem vorhergehenden Anspruch angegeben, ferner **dadurch gekennzeichnet**, daß die zweite Schwellenspannung kleiner als null ist.

13. Eine integrierte, logische Schaltung, wie in Anspruch 12 angegeben, ferner **dadurch gekennzeichnet**, daß sie einschließt:

eine zweite Eingangssignalklemme (A'); und

einen fünften Feldeffekt-Transistor (58) auf dem genannten Substrat (60), der die erste Schwellenspannung hat, ein Gate hat, das mit der zweiten Eingangssignalklemme (A') gekoppelt ist, eine Drain hat, die mit der genannten Drain des genannten ersten Transistors (24) und mit der ersten Stromquelle ($V_{DD}$) gekoppelt ist, und eine Source hat, die mit der genannten Source des genannten ersten Transistors (24) gekoppelt ist.

14. Eine integrierte, logische Schaltung, wie in Anspruch 13 angegeben, die ferner **dadurch gekennzeichnet**, daß der genannten fünfte Transistor (58) ein Metall-Halbleiter-Feldeffekt-Transistor ist.

15. Eine integrierte, logische Schaltung, wie in Anspruch 13 angegeben, ferner **dadurch gekennzeichnet**, daß der genannte fünfte Transistor (58) ein Feldeffekt-Transistor mit Heteroübergang ist.

16. Eine integrierte, logische Schaltung, wie in irgendeinem der Ansprüche 13 bis 15 angegeben, ferner **dadurch gekennzeichnet**, daß die genannte logische Schaltung eine NICHTODER-Schaltung mit zwei Eingängen ist.

17. Eine integrierte, logische Schaltung, wie in Anspruch 13 angegeben, ferner **dadurch gekennzeichnet**, daß eine Mehrzahl der genannten NICHTODER-Schaltungen mit zwei Eingängen miteinander verbunden sind, um die genannten integrierten, logischen Schaltkreise zu bilden.

18. Eine integrierte, logische Schaltung, wie in irgendeinem der Ansprüche 1 bis 17 angegeben, ferner **dadurch gekennzeichnet**, daß die jeweiligen Stromquellen, die dem genannten ersten und zweiten Stromzuführknoten ($V_{DD}$, $V_{SS}$) Strom liefern, während des Betriebes der genannten logischen Schaltung mit Siliziumschaltungen kompatibel sind.

19. Eine integrierte, logische Schaltung, wie in irgendeinem der Ansprüche 1 bis 18 angegeben, ferner **dadurch gekennzeichnet**, daß die genannte logische Schaltung nur die erste und zweite Stromquelle einschließt.

20. Eine integrierte, logische Schaltung, wie in irgendeinem der Ansprüche 1 bis 19 angegeben, ferner **dadurch gekennzeichnet**, daß das genannte Substrat (60) GaAs einschließt.

21. Eine integrierte, logische Schaltung, wie in irgendeinem der Ansprüche 1-4 angegeben, ferner **dadurch gekennzeichnet**, daß die genannte logische Schaltung eine Mehrzahl von Ausgangsverzweigungs-Transistoren einschließt.

22. Eine integrierte, logische Schaltung, wie in irgendeinem der Ansprüche 1-21 angegeben, wobei die genannte logische Schaltung aus einer Kaskaden-Feldeffekt-Transistor-Logik (CFL) hergestellt ist.

**Revendications**

1. Circuit logique intégré comprenant :

un substrat semiconducteur composite du groupe III-V (60) ;

une borne de signal d'entrée (A) ;

une borne de signal de sortie ($\overline{A}$) ;

un premier noeud d'alimentation ($V_{DD}$) ;

un second noeud d'alimentation ($V_{SS}$) ;

un premier transistor à effet de champ (24) sur ledit substrat semiconducteur (60), comportant une première grille couplée à la borne de signal d'entrée (A), comportant un premier drain couplé au premier noeud d'alimentation ($V_{DD}$) et comportant une première source ;

un second transistor à effet de champ (22) sur ledit substrat semiconducteur (60), comportant une seconde grille couplée à ladite première source dudit premier transistor à effet de champ (24), comportant une seconde source couplée au second noeud d'alimentation ($V_{SS}$) et comportant un second drain couplé à la borne de signal de sortie ($\overline{A}$) ;

un troisième transistor à effet de champ (20) sur ledit substrat semiconducteur, comportant une troisième grille, comportant une troisième source couplée à la troisième grille et comportant un troisième drain, dans lequel ledit premier noeud d'alimentation ($V_{DD}$) est couplé au troisième drain dudit troisième

13

transistor à effet de champ et la troisième source du troisième transistor à effet de champ est couplée à la borne de signal de sortie (Ā),

    caractérisé en ce qu'il comporte un quatrième transistor à effet de champ (56) sur ledit substrat semiconducteur comportant un quatrième drain couplé à ladite première source dudit premier transistor à effet de champ (24), comportant une quatrième grille et comportant une quatrième source couplée à ladite quatrième grille et audit second noeud d'alimentation ($V_{SS}$) ; et

    dans lequel chacun desdits premier à quatrième transistors à effet de champ est un transistor à effet de champ de jonction (JFET) ou un transistor à effet de champ métal-semiconducteur (MESFET), lesdits premier et second transistors à effet de champ (24, 22) présentent une première tension de seuil, lesdits troisième et quatrième transistors à effet de champ (20, 56) présentent une seconde tension de seuil qui est inférieure à la première tension de seuil et la différence entre la première tension de seuil et la seconde tension de seuil est égale à une constante, ladite constante étant déterminée conformément à des largeurs desdits transistors à effet de champ.

2.     Circuit logique intégré selon la revendication 1, caractérisé en outre en ce que ledit troisième transistor à effet de champ (20) est du type appauvrissement.

3.     Circuit logique intégré selon la revendication 1 ou 2, caractérisé en outre en ce que ledit quatrième transistor à effet de champ (56) est du type appauvrissement.

4.     Circuit logique intégré selon l'une quelconque des revendications 1 à 3, caractérisé en outre en ce que ledit quatrième transistor à effet de champ (56) est un transistor à effet de champ métal-semiconducteur.

5.     Circuit logique intégré selon la revendication 4, caractérisé en outre en ce que ledit troisième transistor à effet de champ (20) est un transistor à effet de champ métal-semiconducteur.

6.     Circuit logique intégré selon l'une quelconque des revendications précédentes, caractérisé en outre en ce que lesdits premier et second transistors à effet de champ (24, 22) sont des transistors à effet de champ métal-semiconducteur.

7.     Circuit logique intégré selon l'une quelconque des revendications 1 à 3, caractérisé en outre en ce que ledit quatrième transistor à effet de champ (56) est un transistor à effet de champ de jonction.

8.     Circuit logique intégré selon la revendication 7, caractérisé en outre en ce que ledit troisième transistor à effet de champ (20) est un transistor à effet de champ de jonction.

9.     Circuit logique intégré selon la revendication 7 ou 8, caractérisé en outre en ce que lesdits premier et second transistors à effet de champ (24, 22) sont des transistors à effet de champ de jonction.

10.     Circuit logique intégré selon l'une quelconque des revendications précédentes, caractérisé en outre en ce que lesdits premier, quatrième, troisième et second transistors (24, 56, 20, 22) ont des largeurs présentant respectivement un rapport d'approximativement 2-2-2-5.

11.     Circuit logique intégré selon la revendication 10, caractérisé en outre en ce que la largeur de chacun desdits premier, quatrième et troisième transistors (24, 56, 20) vaut sensiblement deux micromètres et en ce que la largeur dudit second transistor (22) vaut sensiblement cinq micromètres.

12.     Circuit logique intégré selon l'une quelconque des revendications précédentes, caractérisé en outre en ce que la seconde tension de seuil est inférieure à zéro.

13.     Circuit logique intégré selon la revendication 12, caractérisé en outre en ce qu'il inclut :

    une seconde borne de signal d'entrée (A') ; et

    un cinquième transistor (58) sur ledit substrat (60) présentant la première tension de seuil, comportant une grille couplée à la seconde borne de signal d'entrée (A'), comportant un drain couplé audit drain dudit premier transistor (24) et à la première source d'alimentation ($V_{DD}$) et comportant une source couplée à ladite source dudit premier transistor (24).

14.     Circuit logique intégré selon la revendication 13, caractérisé en outre en ce que ledit cinquième transistor (58) est un transistor à effet de champ métal-semiconducteur.

**15.** Circuit logique intégré selon la revendication 13, caractérisé en outre en ce que ledit cinquième transistor (58) est un transistor à effet de champ de jonction.

**16.** Circuit logique intégré selon l'une quelconque des revendications 13 à 15, caractérisé en outre en ce que ledit circuit logique est un circuit NON-OU à deux entrées.

**17.** Circuit logique intégré selon la revendication 13, caractérisé en outre en ce qu'une pluralité desdits circuits NON-OU à deux entrées sont connectés ensemble pour former lesdits circuits logiques intégrés.

**18.** Circuit logique intégré selon l'une quelconque des revendications 1 à 17, caractérisé en outre en ce que des sources d'alimentation respectives produisant de la puissance pour lesdits premier et second noeuds d'alimentation ($V_{DD}$, $V_{SS}$) pendant le fonctionnement dudit circuit logique sont compatibles avec des circuits en silicium.

**19.** Circuit logique intégré selon l'une quelconque des revendications 1 à 18, caractérisé en outre en ce que ledit circuit logique inclut seulement les première et seconde sources d'alimentation.

**20.** Circuit logique intégré selon l'une quelconque des revendications 1 à 19, caractérisé en outre en ce que ledit substrat (60) inclut du GaAs.

**21.** Circuit logique intégré selon l'une quelconque des revendications 1 à 4, caractérisé en outre en ce que ledit circuit logique inclut une pluralité de transistors de sortance.

**22.** Circuit logique intégré selon l'une quelconque des revendications 1 à 21, ledit circuit logique étant constitué à partir d'une logique de FET en cascade (CFL).

*Fig. 1*

*Fig. 2*

*Fig. 3*

*Fig. 4*

*Fig. 5*

*Fig. 6*

*Fig. 7A*

*Fig. 7B*

*Fig. 7C*